Europäisches Patentamt

**European Patent Office**

**Office européen des brevets**

(11) Numéro de publication: **0 236 181**
A1

## DEMANDE DE BREVET EUROPEEN

(21) Numéro de dépôt: **87400190.2**

(22) Date de dépôt: **28.01.87**

(51) Int. Cl.⁴: **H 03 K 4/00,** H 03 K 4/50

(30) Priorité: **04.02.86 FR 8601520**

(43) Date de publication de la demande: **09.09.87**
**Bulletin 87/37**

(84) Etats contractants désignés: **DE ES FR IT**

(71) Demandeur: **VALEO, 64, avenue de la Grande Armée,**
**F-75848 Paris Cédex 17 (FR)**

(72) Inventeur: **Brenier, Henri, 8 bis, avenue Voltaire,**
**F-78600 Maisons Laffitte (FR)**

(74) Mandataire: **Netter, André et al, Cabinet NETTER 40, rue**
**Vignon, F-75009 Paris (FR)**

(54) **Générateur d'un signal de tension en dents de scie, et dispositif de régulation de la température dans un habitacle de véhicule, comprenant ce générateur.**

㉗ L'invention concerne un générateur d'un signal de tension en dents de scie, comprenant un condensateur (C) chargé par un circuit comprenant un amplificateur opérationnel (A1), et une diode (D1) et une résistance (R6), et deux circuits de décharge en parallèle du condensateur (C), comprenant une résistance (R7) d'une part et une résistance (R8), une diode (D2) et un amplificateur opérationnel d'autre part, qui sont reliés à des niveaux de tension différents pour une décharge du condensateur en deux phases différentes.

L'invention s'applique notamment à la régulation de la température dans un habitacle de véhicule automobile.

0236181

VALEO 280

1

<u>Générateur d'un signal de tension en dents de scie, et dispositif de régulation de la température dans un habitacle de véhicule, comprenant ce générateur.</u>

L'invention concerne un générateur d'un signal de tension en dents de scie, en particulier d'un signal de tension dont la forme en dents de scie comprend des côtés de courbures déterminées, et son application à un dispositif de régulation de la température dans un habitacle de véhicule automobile.

On sait déjà produire un signal de tension en dents de scie par charge et décharge d'un condensateur, au moyen d'un circuit de charge comprenant un amplificateur opérationnel dont la sortie est reliée par une diode et une résistance à une borne du condensateur pour le charger, une première entrée de cet amplificateur étant reliée à une tension d'alimentation par un pont diviseur et à la sortie de l'amplificateur par une boucle de réaction, tandis que l'autre entrée de l'amplificateur est reliée à la borne précitée du condensateur. Le signal de tension en dents de scie qui est ainsi obtenu a une forme relativement régulière, les côtés des dents de scie étant sensiblement rectilignes.

Dans certaines applications, il est souhaitable que les côtés des dents de scie du signal de tension aient une forme non rectiligne, pour l'obtention de caractéristiques particulières procurées par un circuit commandé par ce signal de tension.

Par exemple, ce signal de tension peut être comparé à une tension de commande dans un amplificateur opérationnel pour fournir en sortie des créneaux de tension utilisés pour commander une électrovanne autorisant ou interdisant respectivement le passage d'un fluide caloporteur dans un échangeur de chaleur faisant partie de l'installation de chauffage ou de climatisation d'un habitacle de véhicule automobile. Dans ce cas, la tension de commande varie en fonction de la différence entre une température de consigne et la température réelle dans l'habitacle, et les créneaux de tension appliqués à l'électrovanne permettent de déterminer un certain débit de fluide caloporteur dans l'échangeur, donc de déterminer une température de l'air qui traverse cet échangeur et qui est admis dans l'habitacle pour faire ainsi varier la température dans l'habitacle. Toutefois, on a constaté que la variation de la température dans l'habitacle en fonction du débit de fluide caloporteur dans l'échangeur de chaleur n'est pas linéaire, la variation de la température dans l'habitacle étant souvent importante pour des faibles débits,lorsque le signal de tension en dents de scie qui est comparé à la tension de commande a une forme régulière.

L'invention a pour objet un générateur d'un signal de tension en dents de scie dont les côtés aient des courbures prédéterminées pour permettre de compenser, par la non-linéarité du signal de tension en dents de scie, par exemple la non-linéarité de la variation de la température en fonction du débit de fluide caloporteur, dans le cas exposé ci-dessus.

L'invention propose donc à cet effet un générateur d'un signal de tension en dents de scie ayant des côtés de courbures déterminées, comprenant un condensateur dont la tension de charge et de décharge forme le signal de sortie du générateur, et un circuit de charge du condensateur, comprenant un amplificateur opérationnel dont la sortie est reliée par une diode et une résistance à une borne du condensateur pour le charger, une première entrée de l'amplificateur étant reliée à une tension d'alimentation par un pont diviseur et à la sortie de l'amplificateur par une boucle de réaction, l'autre entrée de l'amplificateur étant reliée à ladite borne du condensateur, caractérisé en ce que cette borne du condensateur est reliée par deux circuits de décharge en parallèle à deux points ayant des niveaux de tension différents pour produire une décharge du condensateur en deux phases successives différentes.

On peut ainsi faire varier la tension de décharge du condensateur selon deux lois successives prédéterminées, pour obtenir une tension de décharge non linéaire permettant de compenser exactement la non-linéarité de la variation d'un paramètre tel que la température dans l'habitacle d'un véhicule automobile.

Selon une autre caractéristique de l'invention, les circuits de décharge précités sont reliés à des points différents du pont diviseur d'alimentation de l'amplificateur opérationnel du circuit de charge.

L'un des circuits de décharge est par exemple constitué par une résistance et une diode, reliées par un adaptateur d'impédance à un point du pont diviseur ayant une tension supérieure à la tension d'alimentation de l'amplificateur du circuit de charge. L'autre circuit de décharge est par exemple constitué par une résistance connectée entre ladite borne du condensateur et un point du pont diviseur ayant une tension inférieure à la tension d'alimentation de l'amplificateur opérationnel du circuit de charge.

On obtient ainsi un premier circuit de décharge rapide du condensateur, jusqu'à une valeur de tension prédéterminée, et un circuit de décharge lente du condensateur, jusqu'à une tension égale à la tension d'alimentation de l'amplificateur opérationnel du circuit de charge.

L'invention propose également un dispositif de régulation de la température dans un habitacle de véhicule automobile, comprenant un échangeur de chaleur dans lequel circule un fluide caloporteur et qui est traversé par l'air admis dans l'habitacle, une électrovanne montée dans le circuit d'alimentation de l'échangeur pour autoriser ou interdire la circulation du fluide caloporteur dans l'échangeur, et un circuit de commande produisant une tension de commande variant en fonction de la différence entre une température de consigne et la température dans l'habitacle, caractérisé en ce qu'il comprend un générateur d'un signal de tension en dents de scie du type précité, et un comparateur formé par un amplificateur opérationnel dont les entrées sont reliées respectivement à la sortie du circuit de commande et à la sortie du générateur, et dont la sortie est reliée à des moyens de commande en ouverture et en fermeture de l'électrovanne.

En choisissant de façon appropriée les paramètres déterminant la forme du signal de tension en dents de scie fourni par le générateur, on peut compenser la non-linéarité de la variation de la température dans l'habitacle en fonction du débit de fluide caloporteur dans l'échangeur et obtenir ainsi une variation souhaitée de la température en fonction du débit.

Dans la description qui suit, faite à titre d'exemple, on se réfère aux dessins annexés, dans lesquels :

- la figure 1 représente schématiquement un générateur d'un signal de tension en dents de scie selon l'invention;

- la figure 2 représente schématiquement une partie d'un circuit de commande d'un échangeur de chaleur dans une installation de chauffage ou de climatisation pour véhicule automobile;

- la figure 3 représente schématiquement les formes des courbes de tension utilisées dans les circuits des figures 1 et 2;

- la figure 4 représente schématiquement la courbe de variation de l'ouverture d'une électrovanne en fonction de la tension de commande;

- la figure 5 représente schématiquement la variation de la température dans l'habitacle d'un véhicule automobile en fonction du débit de fluide caloporteur dans un échangeur de chaleur.

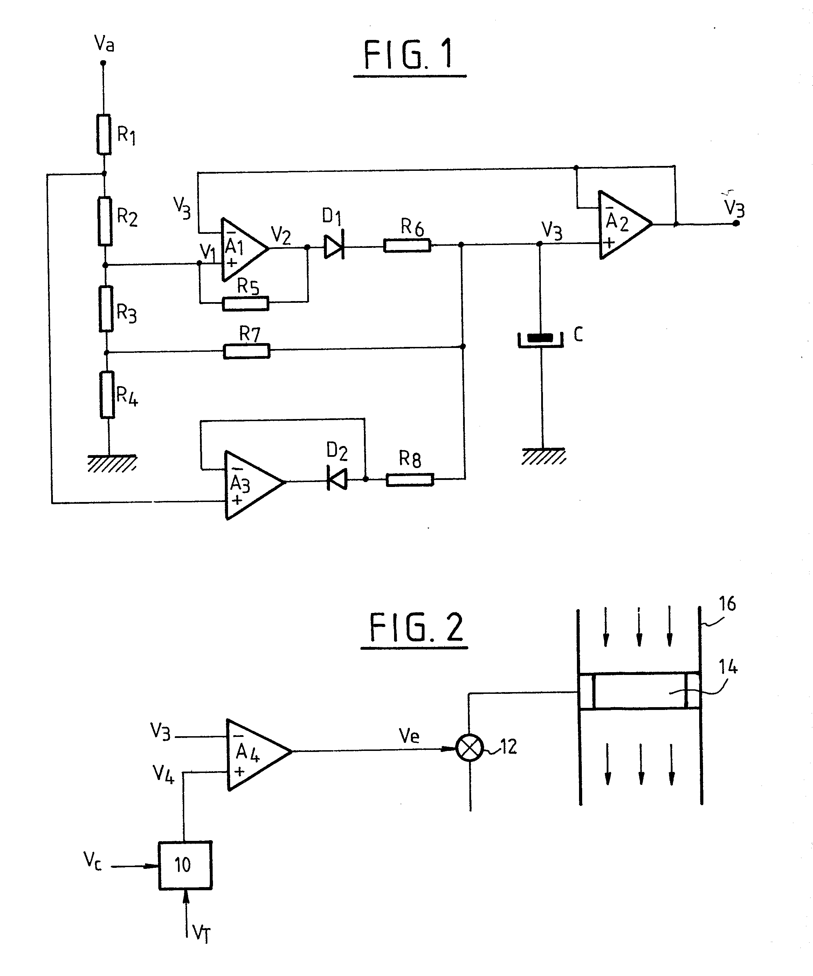

On se réfère d'abord à la figure 1 qui représente le circuit électrique d'un générateur d'un signal de tension en dents de scie selon l'invention.

Ce générateur comprend un circuit de charge d'un condensateur C dont une borne est reliée à la masse et dont l'autre borne est reliée d'une part au circuit de charge, et d'autre part à deux circuits de décharge qui sont montés en parallèle et qui ont des caractéristiques différentes.

Le circuit de charge comprend un amplificateur opérationnel A1 dont l'entrée directe est reliée à une tension d'alimentation Va par les résistances R1 et R2 d'un pont diviseur comprenant deux autres résistances R3 et R4 placées en série avec les résistances R1 et R2 entre la tension d'alimentation Va et la masse. L'entrée directe de l'amplificateur opérationnel A1 est reliée à sa sortie par une résistance R5 formant une boucle de réaction.

La sortie de l'amplificateur opérationnel est reliée par une diode D1 et une résistance R6 à la borne de charge du condensateur C, qui est également reliée par un amplificateur opérationnel A2 monté en suiveur et en adaptateur d'impédance à l'entrée inverse du premier amplificateur opérationnel A1.

Plus précisément, et comme on le voit en figure 1, la borne du condensateur est reliée à l'entrée directe de l'amplificateur A2, dont la sortie est reliée à son entrée inverse et à celle de l'amplificateur A1.

Les circuits de décharge du condensateur C comprennent, d'une part, une résistance R7 connectée entre la borne du condensateur et la borne commune des résistances R3 et R4 du pont diviseur et, d'autre part, une résistance R8 connectée entre la borne du condensateur C et la borne commune des résistances R1 et R2 du pont diviseur par l'intermédiaire d'une diode D2 et d'un amplificateur opérationnel A3 monté en suiveur et en adaptateur d'impédance. On voit que l'entrée directe de l'amplificateur A3 est connectée entre les résistances R1 et R2, que son entrée inverse est reliée à sa sortie entre la résistance R8 et la diode D2, et que la diode D2 est montée de façon à permettre uniquement la décharge du condensateur C et à interdire sa charge.

Ce générateur fonctionne de la façon suivante :

Soient V1 la tension à l'entrée directe de l'amplificateur opérationnel A1, V2 la tension à sa sortie, et V3 la tension aux bornes du condensateur C et à l'entrée inverse de l'amplificateur A1.

Cet amplificateur fonctionne en comparateur. Lorsque la tension V1 est supérieure à la tension V3, la tension V2 de sortie de l'amplificateur A1 est au niveau haut ou niveau 1 et le condensateur C est en charge par l'intermédiaire de la diode D1 et de la résistance R6.

Quand la tension V3 aux bornes du condensateur devient égale à la tension V1, la tension V2 à la sortie de l'amplificateur A1 passe au niveau bas ou niveau 0 et la charge du condensateur C s'arrête.

Supposons par exemple que R1 + R2 = R3 + R4 = R5. Lorsque la tension V2 est au niveau haut ou niveau 1, la résistance R5 est en parallèle avec les résistances R1 + R2, et on a alors V1 = 2Va/3. Quand la tension V2 est au niveau bas ou niveau 0, la résistance R5 est en parallèle avec les résistances R3 + R4, et on a alors V1 = Va/3.

Ainsi, dès que la tension V3 aux bornes du condensateur devient égale à la tension V1 à la fin de la charge du condensateur, la tension V1 passe de 2Va/3 à Va/3 et le condensateur se décharge par les deux circuits de décharge constitués par la résistance R7 d'une part et par la résistance R8, la diode D2 et l'amplificateur opérationnel A3 d'autre part.

Le circuit de décharge formé par la résistance R8, la diode D2 et l'amplificateur A3 permet d'obtenir une décharge du condensateur du niveau de tension initial à un niveau de tension V1 + ε1, avec ε1 = (Va − V1).R2/(R1 + R2). Quand la tension V3 devient inférieure à la tension V1 + ε1, la diode D2 isole le condensateur de ce circuit de décharge qui, autrement, aurait tendance à recharger le condensateur.

Le deuxième circuit de décharge formé par la résistance R7 est connecté entre la borne du condensateur et un niveau de tension égal à V1 − ε2, avec ε2 = V1.R3/(R3+R4). La décharge à travers ce deuxième circuit est permanente et s'arrête quand V3 devient égale à V1, qui passe alors de la valeur Va/3 à la valeur 2Va/3, de sorte que la charge du condensateur recommence.

La résistance R7 est choisie supérieure à la résistance R8, pour obtenir par exemple une courbe de décharge relativement lente par le deuxième circuit de décharge constitué par la résistance R7.

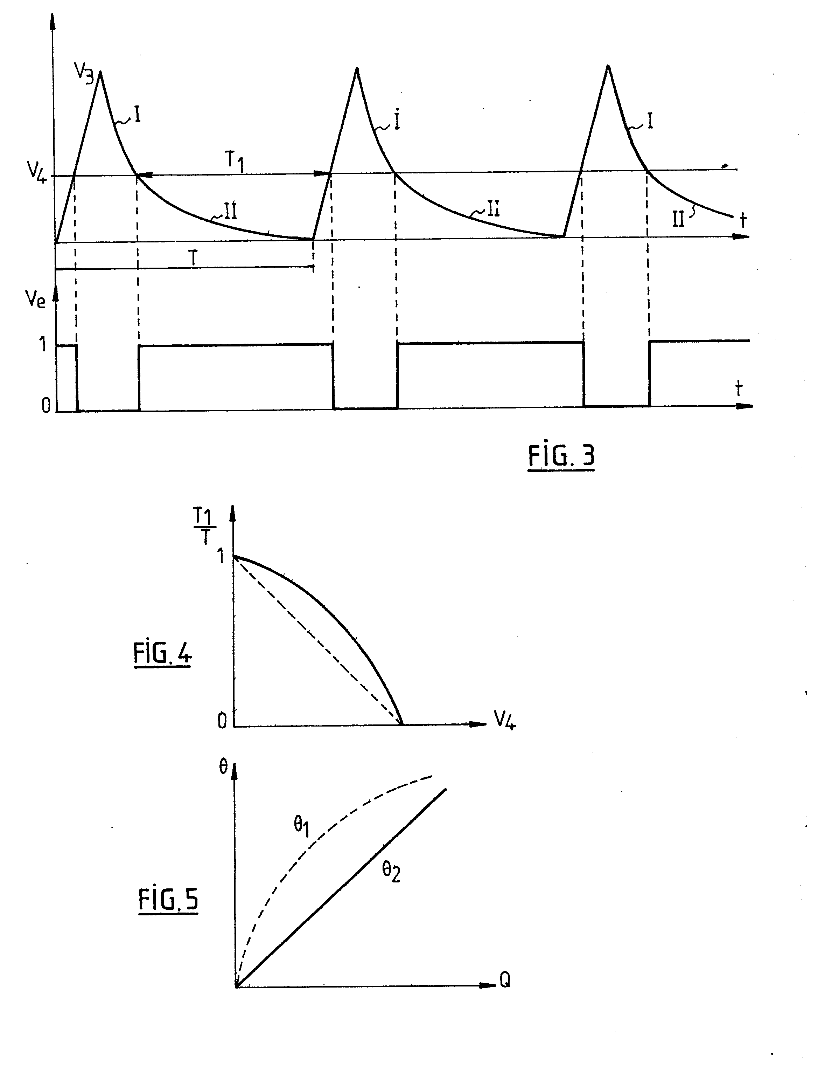

La variation de la tension V3 aux bornes du condensateur en fonction du temps est représentée en figure 3, où l'on voit que la courbe de charge du condensateur est sensiblement rectiligne et que sa courbe de décharge comprend une première partie I, correspondant à la décharge du condensateur simultanément à travers les deux circuits de décharge, et une seconde partie II correspondant à la décharge du condensateur uniquement à travers la résistance R7.

On comprend que, en choisissant de façon appropriée les valeurs des résistances R1 à R8 et de la capacité du condensateur C, on obtient un signal de tension V3 en dents de scie ayant une périodicité T et une courbure souhaitées.

On se réfère maintenant à la figure 2 représentant une application particulière de ce générateur à la régulation de la température dans un habitacle de véhicule automobile.

Le signal de sortie V3 du générateur de la figure 1 est appliqué à l'entrée inverse d'un amplificateur opérationnel A4 fonctionnant en comparateur, dont l'entrée directe reçoit une tension V4 déterminée par un circuit 10 en fonction de la différence entre deux tensions Vc et $V_T$ représentant respectivement une température de consigne et la température dans l'habitacle du véhicule automobile. Le signal Ve de sortie de l'amplificateur A4 commande en ouverture ou en fermeture une électrovanne 12 montée dans le circuit d'alimentation en fluide caloporteur d'un échangeur de chaleur 14 faisant partie d'une installation de chauffage ou de climatisation de véhicule automobile. Cet échangeur de chaleur 14 est placé dans un conduit 16 dans lequel passe l'air admis dans l'habitacle du véhicule, cet air traversant donc l'échangeur de chaleur 14
pour que sa température soit modifiée par le fluide caloporteur qui circule dans cet échangeur.

Le signal Ve de commande de l'électrovanne 12 est un signal
de tension en créneau, résultant de la différence entre
les tensions V3 et V4.

On prévoit par exemple, comme représenté en figure 3,
que la tension Ve est au niveau 1 si V4 est supérieur
à V3, et qu'elle est au niveau 0 si V4 est inférieur à
V1, l'électrovanne 12 étant commandée en fermeture si
la tension Ve est au niveau 1. La durée T1 représentée
en figure 3 est donc la durée d'une période de fermeture
de l'électrovanne 12.

Lorsque le signal V3 de tension en dents de scie a une
forme régulière, la variation du rapport T1/T en fonction
de la tension V4 est représentée en figure 4 par une droite
en trait pointillé, T étant la période du signal de tension V3. On obtient alors la courbe θ1 (représentée en trait
pointillé en figure 5) de variation de la température
dans l'habitacle en fonction du débit Q de fluide caloporteur dans l'échangeur 14, ce débit Q étant lui-même
déterminé par les durées d'ouverture et de fermeture de
l'électrovanne 12. Cette courbe augmente rapidement pour
les faibles valeurs du débit Q et n'est pas linéaire.

Par contre, lorsque le signal de tension V3 n'est pas
régulier et a la forme représentée en figure 3, on obtient la courbe de la variation de T1/T en fonction de
la tension de commande V4 qui est représentée en trait
plein en figure 4, qui n'est pas linéaire, cette non-linéarité permettant de compenser la non-linéarité naturelle de la courbe de la variation de température dans l'habitacle en fonction du débit Q de fluide caloporteur, et donc d'obtenir la courbe sensiblement linéaire $\theta 2$ représentée en trait plein en figure 5.

0236181

Revendications.

1. Générateur d'un signal de tension en dents de scie ayant des côtés de courbures déterminées, comprenant un condensateur (C) dont la tension de charge et de décharge forme le signal de sortie (V3) du générateur et un circuit de charge du condensateur comprenant un amplificateur opérationnel (A1) dont la sortie est reliée par une diode (D1) et une résistance (R6) à une borne du condensateur (C) pour le charger, une première entrée de l'amplificateur (A1) étant reliée à une tension d'alimentation (Va) par un pont diviseur (R1, R2, R3, R4) et à la sortie de l'amplificateur (A1) par une boucle de réaction (R5), l'autre entrée de l'amplificateur étant reliée à ladite borne du condensateur (C), caractérisé en ce que cette borne du condensateur est reliée par deux circuits de décharge parallèles (R7; R8, D2, A3) à deux points ayant des niveaux de tension différents pour produire une décharge du condensateur en deux phases successives différentes.

2. Générateur selon la revendication 1, caractérisé en ce que les circuits de décharge sont reliés à deux points différents du pont diviseur (R1, R2, R3, R4) d'alimentation dudit amplificateur opérationnel (A1).

3. Générateur selon la revendication 2, caractérisé en ce qu'un premier circuit de décharge est relié à un point du pont diviseur ayant une tension supérieure à la tension d'alimentation dudit amplificateur opérationnel (A1), par une résistance (R8) et une diode (D2).

4. Générateur selon la revendication 3, caractérisé en ce que ce premier circuit de décharge comprend un amplificateur opérationnel (A3) fonctionnant en suiveur et en adaptateur d'impédance.

5. Générateur selon l'une des revendications 2 à 4, caractérisé en ce que le deuxième circuit de décharge est formé par une résistance R7 connectée entre ladite borne
du condensateur (C) et un point du pont diviseur ayant
une tension inférieure à la tension d'alimentation dudit
amplificateur opérationnel (A1) du circuit de charge du
condensateur.

6. Générateur selon la revendication 5, caractérisé en
ce que la résistance (R7) du deuxième circuit de décharge
a une valeur supérieure à celle de la résistance (R8)
du premier circuit de décharge.

7. Générateur selon l'une des revendications précédentes,
caractérisé en ce que ladite borne du condensateur (C)
est reliée par un amplificateur opérationnel (A2) fonctionnant en suiveur et en adaptateur d'impédance à l'autre
entrée de l'amplificateur opérationnel (A1) du circuit
de charge.

8. Dispositif de régulation de la température dans un
habitacle de véhicule automobile, comprenant un échangeur
de chaleur (14) dans lequel circule un fluide caloporteur
et qui est traversé par l'air admis dans l'habitacle,
une électrovanne (12) montée dans le circuit d'alimentation de l'échangeur (14) pour autoriser ou interdire la
circulation de fluide caloporteur dans l'échangeur, et
un circuit de commande (10) produisant une tension de
commande (V4) variant en fonction de la différence entre
une température de consigne et la température dans l'habitacle, caractérisé en ce qu'il comprend un générateur
de signal de tension en dents de scie selon l'une des
revendications 1 à 7, et un comparateur formé par un amplificateur opérationnel (A4) dont les entrées sont reliées
respectivement à la sortie du circuit de commande (10)
et à la sortie dudit générateur, et dont la sortie est
reliée à des moyens de commande en ouverture et en fermeture de l'électrovanne (12).

## FIG. 1

## FIG. 2

FIG. 3

FIG. 4

FIG. 5

Office européen
des brevets

Numéro de la demande

EP 87 40 0190

# RAPPORT DE RECHERCHE EUROPEENNE

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | FR-A-2 447 655 (BLAUPUNKT) <br> * Page 3, ligne 31 - page 4, ligne 24; figure * | 1,2,5 | H 03 K 4/00 <br> H 03 K 4/50 |
| Y | DE-B-1 229 140 (ATLAS-WERKE AG) <br> * Colonne 1, ligne 46 - colonne 3, ligne 12; figures 2,4 * | 1,2,5 | |
| A | ELECTRONICS INTERNATIONAL, vol. 53, no. 16, 17 juillet 1980, pages 123,125, New York, US; R.K. KIRSCHMAN: "Adjustable ex generator colors synthesizer's sounds" <br> * Page 123, figure; page 125, colonne de gauche, ligne 5 - colonne de droite, ligne 12 * | 1-7 | |
| A | FR-A-2 423 811 (SOCIETE ANONYME FRANCAISE DU FERODO et al.) <br> * Page 9, ligne 10 - page 11; figures 5-8 * | 8 | DOMAINES TECHNIQUES RECHERCHES (Int. Cl.4) <br><br> H 03 K <br> G 05 D |
| A | DE-A-3 307 220 (WILMS) <br> * Page 19, dernier alinéa - page 22, premier alinéa; figure 3 * | 1,2,8 | |

Le présent rapport de recherche a été établi pour toutes les revendications

| Lieu de la recherche | Date d'achèvement de la recherche | Examinateur |
|---|---|---|
| LA HAYE | 07-05-1987 | CANTARELLI R.J.H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82